# EUROPÄISCHE PATENTSCHRIFT

(11) **EP 0 410 029 B1**
(45) Veröffentlichungstag und Bekanntmachung des Hinweises auf die Patenterteilung: **04.01.1995**
(21) Anmeldenummer: 89113676.4
(22) Anmeldetag: 25.07.1989
(51) Int. Cl.: H03D 13/00, H03L 7/089

(54) **Schaltungsanordnung zur Nachlaufsynchronisation**
Phase synchronization circuit arrangement using feedback
Circuit de synchronisation de phase par asservisssement

(43) Veröffentlichungstag der Anmeldung: 30.01.1991
(73) Patentinhaber: SIEMENS AKTIENGESELLSCHAFT, 80333 München (DE)
(72) Erfinder: Werker, Heinz, Dipl.-Ing., D-8057 Eching (DE)

(56) Entgegenhaltungen:
- WO-A-88/08644
- DE-A- 2 414 285
- GB-A- 2 075 294
- GB-A- 2 194 714

## Beschreibung

Die Erfindung betrifft eine Schaltungsanordnung zur Nachlaufsynchronisation nach dem Oberbegriff des Patentanspruches 1.

Ein insbesondere in der Nachrichtentechnik häufig angewendetes Regelungsprinzip, beispielsweise zur Frequenzdemodulation und zur Frequenzvervielfachung, ist die Nachlaufsynchronisation (Phase-Locked-Loop, PLL). Dabei wird die Frequenz eines Oszillators so eingestellt, daß sie mit einer Bezugsfrequenz übereinstimmt, und zwar so genau, daß die Phasenverschiebung nicht wegläuft. Ubliche Schaltungsanordnungen zur Nachlaufsynchronisation weisen dazu einen steuerbaren Oszillator auf, dessen Ausgangssignal in einem Phasendetektor mit einer Bezugsfrequenz verglichen wird, dessen Ausgangssignal wiederum über eine Regelstrecke die Frequenz des steuerbaren Oszillators einstellt.

Beispielsweise aus Floyd M. Gardner, Charge-Pump Phase-Lock Loops, IEEE Transactions on Communications, VOL. COM-28, Nr. 11, November 1980, ist eine Anordnung bekannt, bei der als Regelstrecke eine Ladungspumpe mit nachgeschaltetem Schleifenfilter eingesetzt wird. Beim Auftreten einer Phasenverschiebung zwischen einem Referenzsignal und dem Ausgangssignal des steuerbaren Oszillators wird die Ladungspumpe derart durch den Phasendetektor angesteuert, daß das Schleifenfilter impulsförmig geladen bzw. entladen wird. Im eingerasteten Zustand der Schaltungsanordnung, d.h. wenn nahezu keine Phasenverschiebung auftritt, werden keine Lade- bzw. Entladeimpulse mehr erzeugt. Das Ausgangssignal des Schleifenfilters - bei der bekannten Schaltungsanordnung ist dies beispielsweise die Spannung über dem Kondensator eines als passivem RC-Glied ausgebildeten Schleifenfilters - bleibt somit eingeprägt und es erfolgt keine Regelung. Der Jitterbereich der gesamten Anordnung hängt dann im wesentlichen von den internen Gatterlaufzeiten im Phasendetektor ab.

Für viele Anwendungen ist jedoch der sich daraus ergebende Jitter zu groß.

Aufgabe der Erfindung ist es daher, eine Schaltungsanordnung zur Nachlaufsynchronisation anzugeben, bei der ein geringerer Jitter auftritt.

Diese Aufgabe wird bei einer gattungsgemäßen Schaltungsanordnung durch die kennzeichnenden Merkmale des Patentanspruches 1 gelöst.

Vorteil der Erfindung ist es, daß mit geringem schaltungstechnischem Aufwand eine deutliche Verringerung des Jitters erzielt wird.

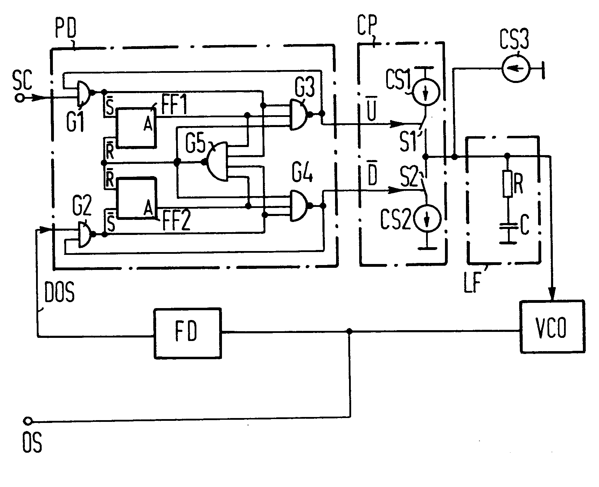

Die Erfindung wird nachfolgend anhand des in der einzigen FIG der Zeichnung dargestellten Ausführungsbeispiels näher erläutert.

Das Ausführungsbeispiel gemäß der Zeichnung zeigt eine Ausführungsform einer erfindungsgemäßen Schaltungsanordnung zur Nachlaufsynchronisation als Frequenzvervielfacher. Dazu ist ein Phasendetektor PD, der mit einem Referenzsignal SC und mit dem Ausgangssignal OS eines steuerbaren Oszillators VCO beaufschlagt ist, eine durch den Phasendetektor PD steuerbare Ladungspumpe CP, ein der Ladungspumpe CP nachgeschaltetes Schleifenfilter LF, ein spannungsgesteuerter Oszillator VCO, dessen Eingang mit dem Ausgang des Schleifenfilters verbunden ist, und ein Frequenzteiler FD, der die Frequenz des Ausgangssignals OS des gesteuerten Oszillators VCO um einen gegebenen Wert teilt und damit das Ausgangssignal DOS abgibt, vorgesehen.

Der Phasendetektor PD besteht aus fünf NAND-Gattern G1...G5 und zwei RS-Flip-Flops FF1,FF2. Ein Eingang des Gatters G1 ist mit dem Referenzsignal SC und der andere Eingang mit einem Ausgangssignal U̅ des Phasendetektors PD beaufschlagt. Das Gatter G2 ist zum einen mit dem Signal DOS und zum anderen mit dem anderen Ausgangssignal D̅ des Phasendetektors PD beaufschlagt. Der Ausgang des Gatters G1 ist auf den invertierenden Seteingang S̅ des Flip-Flops FF1, auf den ersten Eingang des Gatters G3 und auf den ersten Eingang des Gatters G5 geführt. Entsprechend ist der Ausgang des Gatters G2 auf den invertierenden Seteingang S̅ des Flip-Flops FF2, auf den ersten Eingang des Gatters G4 und auf den zweiten Eingang des Gatters G5 angeschlossen. Der Ausgang A des Flip-Flops FF1 ist einerseits mit dem zweiten Eingang des Gatters G3 und andererseits mit dem dritten Eingang des Gatters G5 verbunden. Der Ausgang A des Flip-Flops FF2 ist mit dem zweiten Eingang des Gatters G4 und mit dem vierten Eingang des Gatters G5 verschaltet. An den Ausgang des Gatters G5 sind die invertierenden Reset-Eingänge R̅ der beiden Flip-Flops FF1 und FF2 sowie die dritten Eingänge der Gatter G3 und G4 angeschlossen. Der Ausgang des Gatters G3 führt das Signal U̅ und der Ausgang des Gatters G4 das Signal D̅.

Die Ladungspumpe CP weist zwei auf Bezugspotential liegende Stromquellen CS1 und CS2 zur Ladung bzw. Entladung des Schleifenfilters LF auf, die jeweils über einen steuerbaren Schalter S1 und S2 auf das Schleifenfilter LF aufschaltbar sind. Dabei wird der Schalter S1 durch das Signal U̅ und der Schalter S2 durch das Signal D̅ gesteuert. Das Schleifenfilter LF selbst besteht aus einer vom Ausgang der Ladungspumpe CP bzw. vom Eingang des gesteuerten Oszillators VCO auf Bezugspotential führenden Reihenschaltung aus einem Widerstand R und einem Kondensator C.

Erfindungsgemäß ist dem Ausgang der Ladungspumpe CP eine weitere Ladungspumpe - im gezeigten Ausführungsbeispiel handelt es sich dabei um eine an dem Bezugspotential liegende weitere, beispielsweise ladende Stromquelle CS3 - parallelgeschaltet. Bei eingerasteter Schaltungsanordnung wird dadurch die Frequenz des Ausgangssignales OS des steuerbaren Oszillators VCO immer in eine Vorzugsrichtung geregelt und dadurch der Jitter sehr stark verringert.

Bei der Anwendung als Frequenzvervielfacher wird allgemein jeweils ein Frequenzteiler vor die Eingänge des Phasendetektors geschaltet. Im vorliegenden Ausführungsbeispiel ist dazu lediglich der Frequenzteiler FD zwischen den Ausgang des gesteuerten Oscillators VCO und einem Eingang des Phasendetektors PD geschaltet. Neben der Anwendung als Frequenzvervielfacher ist aber auch der Einsatz beispielsweise als Frequenzdemodulator und -detektor in gleicher Weise möglich. Ebenso sind auch vom Ausführungsbeispiel abweichende Ausgestaltungen des Phasendetektors, der Ladungspumpe und des Schleifenfilters möglich.

## Patentansprüche

1. Schaltungsanordnung mit einem Phasendetektor (PD), der mit einem Referenzsignal (SC) und mit dem Ausgangssignal (OS) eines steuerbaren Oszillators (VCO) beaufschlagt ist, und mit einer durch den Phasendetektor (PD) steuerbaren Ladungspumpe (CP), die unter Zwischenschaltung eines Schleifenfilters (LF) zur Ansteuerung des Oszillators (VCO) vorgesehen ist, wobei die steuerbare Ladungspumpe (CP) zur Ladung bzw. Entladung des Schleifenfilters (LF) vorgesehen ist,
**gekennzeichnet durch**
eine weitere nicht gesteuerte Ladungspumpe (CS3), welche einen Konstantstrom liefert, die dem Ausgang der steuerbaren Ladungspumpe (CP) parallelgeschaltet ist.

## Claims

1. Circuit configuration having a phase detector (PD), which is acted upon by a reference signal (SC) and by the output signal (OS) of a controllable oscillator (VCO), and having a charge pump (CP) which is controllable by the phase detector (PD) and which is provided, with interposition of a loop filter (LF), to drive the oscillator (VCO), the controllable charge pump (CP) being provided to charge or respectively discharge the loop filter (LF), characterized by a further, non-controlled charge pump (CS3), which delivers a constant current and which is connected in parallel with the output of the controllable charge pump (CP).

## Revendications

1. Montage comportant un détecteur (PD) de phase, qui reçoit un signal (SC) de référence et le signal (OS) de sortie d'un oscillateur (VCO) commandable, et une pompe (CP) de charge, qui peut être commandée par le détecteur (PD) de phase et qui est montée en intercalant un filtre (LF) de boucle destiné à commander l'oscillateur (VCO), la pompe (CP) commandable de charge étant prévue pour charger ou décharger le filtre (LF) de boucle,
caractérisé par
une autre pompe (CS3) non commandée de charge, qui fournit un courant constant et qui est branchée en parallèle à la sortie de la pompe (CP) commandable de charge.
